# EUROPEAN PATENT APPLICATION

(11) **EP 4 625 726 A1**
(43) Date of publication of application: **01.10.2025**
(21) Application number: 22969014.4
(22) Date of filing: 23.12.2022
(51) Int. Cl.: H01S 3/13

(54) **LASER, OPTICAL MODULE, AND APPARATUS**

(71) Applicant: Huawei Technologies Co., Ltd., Shenzhen, Guangdong 518129 (CN)
(72) Inventor: LI, Xiaokun, Shenzhen, Guangdong 518129 (CN); YANG, Kun, Shenzhen, Guangdong 518129 (CN); LV, Gen, Shenzhen, Guangdong 518129 (CN); QIN, Yang, Shenzhen, Guangdong 518129 (CN); WANG, Dingding, Shenzhen, Guangdong 518129 (CN)
(74) Representative: Gill Jennings & Every LLP
(86) International application number: PCT/CN2022/141568
(87) International publication number: WO 2024/130727

(57) **Abstract**

A laser, an optical module, and an apparatus are provided. The laser includes a gain region waveguide (11), a feedback waveguide (12), a first end face (R1), and a second end face (R2). The gain region waveguide (11) and the feedback waveguide (12) are located between the first end face (R1) and the second end face (R2), an end of the gain region waveguide (11) is connected to an end of the feedback waveguide (12), and the feedback waveguide (12) is located on a side that is of the gain region waveguide (11) and that is close to the second end face (R2). The first end face (R1) and the second end face (R2) are configured to transmit light in the gain region waveguide (11) and the feedback waveguide (12), and the first end face (R1) is configured to transmit laser light. The feedback waveguide (12) is disposed, so that an equivalent cavity length of the laser can be increased, to compress a linewidth of the laser. In addition, integration of the laser can be improved, and material costs and processing costs of the laser can be reduced.

## Description

### TECHNICAL FIELD

This application relates to the field of communication technologies, and in particular, to a laser, an optical module, and an apparatus.

### BACKGROUND

With the gradual increase of bandwidth in the future, optical communication technologies are gradually widely applied, and the optical communication technologies may be applied to a wireless scenario. However, the optical communication technologies impose a higher requirement on a linewidth of a laser. For example, based on a mainstream modulation format of quadrature amplitude modulation (quadrature amplitude modulation, QAM16) in current communication technologies, the linewidth of the laser needs to be less than 5 MHz, and a higher modulation format indicates a higher requirement on the linewidth. In addition, a narrower linewidth also helps reduce power consumption of optical digital signal processing (optical digital signal processing, oDSP). Therefore, how to reduce the linewidth of the laser is a technical problem that needs to be urgently resolved.

### SUMMARY

Embodiments of this application provide a laser, an optical module, and an apparatus, to reduce a linewidth of the laser.

According to a first aspect, an embodiment of this application provides a laser. The laser may be various types of lasers. For example, the laser may be a distributed feedback laser (distribution feedback laser, DFB). The laser in this embodiment of this application may include a gain region waveguide, a feedback waveguide, a first end face, and a second end face. The gain region waveguide and the feedback waveguide are located between the first end face and the second end face, an end of the gain region waveguide is connected to an end of the feedback waveguide, and the feedback waveguide is located on a side that is of the gain region waveguide and that is close to the second end face. The first end face and the second end face are configured to transmit light in the gain region waveguide and the feedback waveguide, and the first end face is configured to transmit laser light.

In this embodiment of this application, both the gain region waveguide and the feedback waveguide are waveguides having an optical transmission function. Light in the gain region waveguide is directed to the second end face after being transmitted through the feedback waveguide. The second end face can reflect the light back to the feedback waveguide, so that the reflected light is directed to the first end face after being transmitted through the feedback waveguide and the gain region waveguide. The first end face has a reflection function, and can reflect the light back to the gain region waveguide. Therefore, the light is reflected back and forth between the first end face and the second end face, to form resonance. The first end face further has a transmission function, and an obtained laser light with a narrow linewidth may be emitted through the first end face.

In the laser provided in this embodiment of this application, the feedback waveguide connected to the gain region waveguide is disposed, so that an equivalent cavity length of the laser can be increased, to reduce a resonant cavity loss and a threshold gain of the laser, and compress a linewidth of the laser. In addition, the feedback waveguide is monolithically integrated inside the laser, and there is no need to dispose an external cavity outside a cavity of the laser, so that integration of the laser can be improved, and material costs and processing costs of the laser can be reduced.

In a possible implementation, the gain region waveguide may include an indium gallium arsenide phosphide (InGaAsP) material, and the feedback waveguide may include the indium gallium arsenide phosphide (InGaAsP) material. Certainly, the gain region waveguide and the feedback waveguide may alternatively include other materials. This is not limited herein. Impurities of a specific material are doped in both the gain region waveguide and the feedback waveguide, and doping concentrations in the gain region waveguide and the feedback waveguide are different, so that the gain region waveguide and the feedback waveguide have different refractive indexes. In addition, the gain region waveguide and the feedback waveguide may be in a straight-line shape, to perform a good optical transmission function.

During specific implementation, a thickness of the gain region waveguide may be less than or equal to 2 micrometers (micrometer, µm), and a thickness of the feedback waveguide may be less than or equal to 2 µm. In this way, the thicknesses of the gain region waveguide and the feedback waveguide are equivalent to a wavelength of light, so that the light in the gain region waveguide and the feedback waveguide satisfies a wave optical transmission rule, and the light can be transmitted inside the gain region waveguide and the feedback waveguide. Certainly, in some cases, the thicknesses of the gain region waveguide and the feedback waveguide may alternatively be slightly greater than 2 µm, provided that light can be transmitted inside the gain region waveguide and the feedback waveguide. The thicknesses of the gain region waveguide and the feedback waveguide are not limited herein.

In a possible implementation, the laser provided in this embodiment of this application may further include a substrate, and the substrate is configured to bear the gain region waveguide and the feedback waveguide, so that the gain region waveguide and the feedback waveguide can be integrated on the same substrate. Optionally, the substrate may include an indium phosphide material, an indium gallium arsenide aluminum material, or an indium gallium aluminum arsenide material. Certainly, the substrate may alternatively include another material. This is not limited herein.

The laser in this embodiment of this application may further include a gain material layer. The gain material layer is located between the substrate and the gain region waveguide, and the gain material layer may be configured to emit light under control of an electrical signal. During specific implementation, the gain material layer may be disposed in a region corresponding to the gain region waveguide. In this way, the light emitted from the gain material layer may be directed into the gain region waveguide. A passive material is used between the feedback waveguide and the substrate, and the passive material does not emit light under control of an electrical signal, to avoid impact of spontaneous radiation on linewidth broadening of the laser.

In some embodiments of this application, the feedback waveguide may be configured to adjust, under control of an electrical signal, a phase of light transmitted in the feedback waveguide. A refractive index of the feedback waveguide may be adjusted by applying the electrical signal to the feedback waveguide, to adjust the phase of the light transmitted in the feedback waveguide, thereby implementing single-longitudinal-mode lasing of the laser. The laser may further include a first electrode. The first electrode may be located at a position corresponding to the feedback waveguide, and the first electrode may be configured to provide an electrical signal for the feedback waveguide.

In a possible implementation, the laser in this embodiment of this application may further include an electrode layer. The electrode layer may include the first electrode, a second electrode, and an isolation region. The isolation region may be configured to separate the first electrode from the second electrode. The first electrode is located at the position corresponding to the feedback waveguide, and the first electrode may be configured to provide an electrical signal for the feedback waveguide. The second electrode is located at a position corresponding to the gain region waveguide, and the second electrode may be configured to provide an electrical signal for the gain material layer of the laser.

The first electrode and the second electrode are separated by the isolation region, so that electrical signals between the first electrode and the second electrode can be isolated, thereby separately applying electrical signals to the feedback waveguide and the gain material layer. During specific implementation, the isolation region may be a groove located between the first electrode and the second electrode. Certainly, in some cases, the isolation region may alternatively be a hole that penetrates the electrode layer, provided that the isolation region can electrically isolate the first electrode and the second electrode. A form of the isolation region is not limited herein. A depth of the isolation region may be 0.5 µm to 0.8 µm. For example, the depth of the isolation region may be 0.5 µm, 0.6 µm, or 0.8 µm. A width of the isolation region may be set based on an actual requirement, provided that the isolation region can electrically isolate the first electrode and the second electrode. A size of the isolation region is not limited herein.

During specific implementation, the first electrode and the second electrode may be made of a metal material. In a manufacturing process, the first electrode and the second electrode may be manufactured by using a same processing process. Specifically, a metal layer may be formed first, and a region that is between the first electrode and the second electrode and that corresponds to the metal layer is thinned or hollowed out by etching the metal layer, to obtain the isolation region for isolating the first electrode and the second electrode.

During actual application, a ground point may be provided in the laser, the first electrode may form a path with the ground point, to provide a current signal for the feedback waveguide, and the second electrode may form a path with the ground point, to provide a current signal for the gain material layer. In a working process of the laser, a current applied to the first electrode may be different from a current applied to the second electrode. For example, the current applied to the first electrode may be 10 mA to 20 mA, and the current applied to the second electrode may be greater than 100 mA. Current values of the first electrode and the second electrode may be set based on an actual requirement. This is not limited herein.

In a possible implementation, the laser in this embodiment of this application may further include a grating structure. The grating structure may be located on a side wall of the gain region waveguide. The grating structure may be configured to perform mode selection on light transmitted in the gain region waveguide. A resonance effect on the light is achieved by using a diffraction effect of the grating structure, to select a wavelength.

In the working process of the laser, the gain material layer may emit light in a specific spectral range under control of the electrical signal, and the spectral range is wide. The gain region waveguide and the feedback waveguide do not emit light under action of an electrical signal. Therefore, the gain region waveguide and the feedback waveguide may play a role of optical transmission. Light emitted from the gain material layer is directed into the gain region waveguide. The light in the gain region waveguide is directed to the second end face after being transmitted through the feedback waveguide. The second end face can reflect the light back to the feedback waveguide, so that the reflected light is directed to the first end face after being transmitted through the feedback waveguide and the gain region waveguide. The first end face has a reflection function, and can reflect the light back to the gain region waveguide. Therefore, the light is reflected back and forth between the first end face and the second end face, to form resonance. In a process in which the light is transmitted between the first end face and the second end face, the grating structure may perform mode selection on the light transmitted in the gain region waveguide, and the feedback waveguide may adjust a phase of the light transmitted in the feedback waveguide. A linewidth of the light can be narrowed under action of the grating structure and the feedback waveguide, to obtain laser light with a narrow linewidth. The first end face further has the transmission function, and the obtained laser light with the narrow linewidth may be emitted through the first end face.

In a possible implementation, the first end face may include an anti-reflection coating, so that the first end face has both a reflection function and a transmission function. For example, transmittance of the first end face may be about 90%, and transmittance of a first end face R1 may be set based on an actual requirement. This is not limited herein. The second end face may include a high reflection coating. For example, reflectivity of a second end face R2 may be about 90%, and the reflectivity of the second end face R2 may be set based on an actual requirement. This is not limited herein. In this way, the light can be reflected back and forth in the gain region waveguide and the feedback waveguide between the first end face and the second end face, and formed laser light can be emitted through the first end face.

In addition, the laser in this embodiment of this application may further include a protective layer located on a side that is of the gain region waveguide and the feedback waveguide and that is away from the substrate, and the electrode layer may be located on a side that is of the protective layer and that is away from the substrate. The gain region waveguide, the feedback waveguide, and the grating structure can be protected by disposing the protective layer, to prevent the gain region waveguide, the feedback waveguide, and the grating structure from being damaged by a subsequent manufacturing process.

In some embodiments of this application, a length of the grating structure may be consistent with a length of the gain region waveguide. In this way, a mode selection effect of the grating structure may be good. In a possible implementation, the grating structure may be located on a side that is of the gain region waveguide and that is away from the substrate. In a manufacturing process, after the gain region waveguide and the feedback waveguide are formed on the substrate, the grating structure may be formed on the gain region waveguide. In this way, the gain region waveguide can be manufactured on a flat surface. Certainly, in some cases, the grating structure may alternatively be disposed on a side that is of the gain region waveguide and that is close to the substrate, or the grating structure may be disposed on both a side that is of the gain region waveguide and that is close to the substrate and a side that is of the gain region waveguide and that is away from the substrate. This is not limited herein.

In a possible implementation, the grating structure may include a first adjustment region and a phase-shift adjustment region. A grating period of the phase-shift adjustment region is greater than a grating period of the first adjustment region. The phase-shift adjustment region with a relatively large grating period is provided, to adjust light field distribution in the laser, so that the light field distribution is flatter, and a spatial hole burning effect is reduced, thereby improving a yield rate of lasers. After the feedback waveguide is disposed in the laser, energy of the laser may shift towards a side close to the feedback waveguide. In this embodiment of this application, a central point of the phase-shift adjustment region may be located on a side that is of a middle position of the grating structure and that is close to the feedback waveguide. In this way, the phase-shift adjustment region is close to a position where energy concentrates in the laser, so that the light field distribution is flatter, and the spatial hole burning effect is more effectively prevented.

In a possible implementation, the grating structure may be divided into two regions, namely, the first adjustment region and the phase-shift adjustment region. In another possible implementation, the grating structure may alternatively be divided into three regions. In addition to the first adjustment region and the phase-shift adjustment region, the grating structure may further include a second adjustment region. The phase-shift adjustment region may be located between the first adjustment region and the second adjustment region, and the grating period of the phase-shift adjustment region is greater than a grating period of the second adjustment region. During specific implementation, a specific structure of the grating structure may be set based on an actual requirement. This is not limited herein.

In a possible implementation, a length of the phase-shift adjustment region may be any value (including endpoint values) between 25% and 30% of the length of the grating structure. To be specific, the length of the phase-shift adjustment region may be greater than or equal to 25% of the length of the grating structure, and the length of the phase-shift adjustment region is less than or equal to 30% of the length of the grating structure. For example, the length of the grating structure may be about 1000 µm, and a length of a phase-shift adjustment region P may be about 300 µm. In this way, the length of the phase-shift adjustment region may meet a requirement for adjusting the light field distribution of the laser.

During specific implementation, the length of the grating structure is normalized, an end that is of the grating structure and that is close to the first end face is used as 0, and an end that is of the grating structure and that is close to the second end face is used as 1. The central point of the phase-shift adjustment region may be located at a position that is 0.7 to 0.8 (including endpoint values) of the length of the grating structure. In this way, a position of the phase-shift adjustment region can better match the position where the energy concentrates in the laser, and the spatial hole burning effect can be more effectively suppressed.

According to a second aspect, an embodiment of this application further provides an optical module, and the optical module in this embodiment of this application may include any laser described above. Because the feedback waveguide connected to the gain region waveguide is disposed in the laser, the linewidth of the laser emitted by the laser is narrow. Therefore, an optical signal transmission effect of the optical module including the laser is good. The optical module in this embodiment of this application may further include a silicon optical modulator. A first end face of the laser is connected to the silicon optical modulator. During actual application, a set current may be applied to the laser, so that the laser outputs a fixed light intensity. An internal refractive index of the silicon optical modulator is adjusted, so that laser light emitted by the laser interferes with each other. Coherence enhancement and coherence reduction of light are used to represent 0 or 1, thereby implementing transmission of an optical signal.

According to a third aspect, an embodiment of this application further provides an apparatus, and the apparatus may include any laser described above. Because the feedback waveguide connected to the gain region waveguide is disposed in the laser, the linewidth of the laser emitted by the laser is narrow. Therefore, performance of the apparatus including the laser is also good.

In a possible implementation, the apparatus may be any apparatus in a cellular system related to the 3^{rd} generation partnership project (3^{rd} generation partnership project, 3GPP), for example, any apparatus in a 4G or 5G mobile communication system, or a future-oriented evolved system (for example, a 6G mobile communication system). Alternatively, the apparatus may be any apparatus in an open radio access network (open radio access network, O-RAN or ORAN) or a cloud radio access network (cloud radio access network, CRAN). The apparatus may alternatively be any apparatus in a communication system that integrates the foregoing two or more systems.

The apparatus may alternatively be referred to as an access network device, a RAN entity, an access node, or the like, and forms a part of a communication system, to help a terminal implement radio access. In a possible scenario, the apparatus may be a base station, an evolved nodeB (evolved nodeB, eNodeB), an access point (access point, AP), a transmission reception point (transmission reception point, TRP), a next generation nodeB (next generation nodeB, gNB), a next generation nodeB in a 6^{th} generation (6^{th} generation, 6G) mobile communication system, a base station in a future mobile communication system, an access node in a Wi-Fi system, or the like. The apparatus may be a macro base station, a micro base station, an indoor base station, a relay node, a donor node, or a radio controller in a CRAN scenario. Optionally, the apparatus may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, the apparatus may be a central unit (central unit, CU), a distributed unit (distributed unit, DU), a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may have different names, but a person skilled in the art may understand their meanings. For example, in an ORAN system, the CU may alternatively be referred to as an O-CU (that is, an open CU), the DU may alternatively be referred to as an O-DU, the CU-CP may alternatively be referred to as an O-CU-CP, the CU-UP may alternatively be referred to as an O-CU-UP, and the RU may alternatively be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination thereof.

During specific implementation, the apparatus in this embodiment of this application may alternatively be another apparatus including the laser. A type of the apparatus in this embodiment of this application is not limited herein.

In some implementations of this application, the apparatus may further include an optical module, and the optical module includes the laser. In other words, the laser may be integrated into the optical module. During specific implementation, the laser may alternatively be disposed in another component of the apparatus. For example, the laser may alternatively be disposed in a baseband processing unit (building baseband unit, BBU). Optionally, the laser may be directly integrated onto a baseband board of the BBU.

In some implementations of this application, the laser may be located on a circuit board of the apparatus. For example, the laser may be directly integrated onto the circuit board, or the laser may be pluggably disposed on the circuit board, and may be disposed based on an actual requirement. In this way, costs of the optical module are saved, and a size of the apparatus is reduced.

### BRIEF DESCRIPTION OF DRAWINGS

FIG. 1 is a diagram of a structure of a laser according to an embodiment of this application;
FIG. 2 is a distribution diagram of an internal light field of a laser;
FIG. 3 is a diagram of a structure of a grating structure according to an embodiment of this application;
FIG. 4 is a diagram of another structure of a grating structure according to an embodiment of this application;
FIG. 5 is a diagram of a position of a phase-shift adjustment region according to an embodiment of this application;
FIG. 6 is a diagram of another position of a phase-shift adjustment region according to an embodiment of this application; and
FIG. 7 is a diagram of a structure of a DFB laser according to an embodiment of this application.

### DESCRIPTION OF EMBODIMENTS

To make objectives, technical solutions, and advantages of this application clearer, the following further describes this application in detail with reference to the accompanying drawings. The reference numerals in the accompanying drawings in embodiments of this application are as follows:

10: Substrate; 101: Gain material layer; 11: Gain region waveguide; 12: Feedback waveguide; 13: Grating structure; 14: Protective layer; 15: First electrode; 16: Second electrode; R1: First end face; R2: Second end face; P: Phase-shift adjustment region; Q1: First adjustment region; Q2: Second adjustment region.

It should be noted that same reference numerals in the accompanying drawings of this application denote same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

Optical communication technologies may be applied to a wireless scenario. The optical communication technologies have a high requirement on a linewidth of a laser. For example, based on a mainstream modulation format of quadrature amplitude modulation (quadrature amplitude modulation, QAM16) in current communication technologies, the linewidth of the laser needs to be less than 5 megahertz (megahertz, MHz), and a higher modulation format indicates a higher requirement on the linewidth. In addition, a narrower linewidth also helps reduce power consumption of optical digital signal processing (optical digital signal processing, oDSP). However, it is difficult for a current laser to meet the linewidth requirement of the optical communication technologies.

Based on this, to reduce the linewidth of the laser, embodiments of this application provide a laser, an optical module, and an apparatus. The laser in embodiments of this application may be various types of lasers. For example, the laser may be a distributed feedback laser (distribution feedback laser, DFB). The laser may be applied to an optical communication scenario, for example, may be applied to a wireless short-distance optical communication scenario. The linewidth of the laser in embodiments of this application can be less than 1 MHz, and can meet a wireless transmission requirement on a transmission distance of about 10 kilometers (kilometers, km).

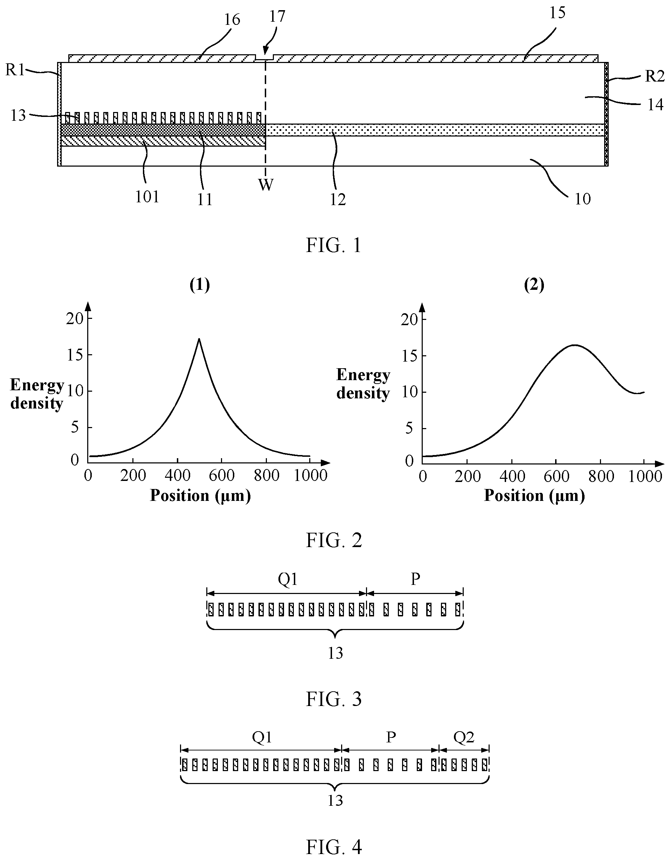

FIG. 1 is a diagram of a structure of a laser according to an embodiment of this application. As shown in FIG. 1, the laser provided in this embodiment of this application may include a gain region waveguide 11, a feedback waveguide 12, a first end face R1, and a second end face R2. The gain region waveguide 11 and the feedback waveguide 12 are located between the first end face R1 and the second end face R2, an end of the gain region waveguide 11 is connected to an end of the feedback waveguide 12, and the feedback waveguide 12 is located on a side that is of the gain region waveguide 11 and that is close to the second end face R2. In FIG. 1, a dashed line W is located between the gain region waveguide 11 and the feedback waveguide 12, to be specific, the gain region waveguide 11 is located on a side that is of the dashed line W and that is close to the first end face R1, and the feedback waveguide 12 is located on a side that is of the dashed line W and that is close to the second end face R2. The first end face R1 and the second end face R2 are configured to transmit light in the gain region waveguide 11 and the feedback waveguide 12, and the first end face R1 is configured to transmit laser light.

The laser in this embodiment of this application may be a distributed feedback laser. During specific implementation, the laser in this embodiment of this application may alternatively be another type of laser. This is not limited herein.

In this embodiment of this application, both the gain region waveguide 11 and the feedback waveguide 12 are waveguides having an optical transmission function. Light in the gain region waveguide 11 is directed to the second end face R2 after being transmitted through the feedback waveguide 12. The second end face R2 can reflect the light back to the feedback waveguide 12, so that the reflected light is directed to the first end face R1 after being transmitted through the feedback waveguide 12 and the gain region waveguide 11. The first end face R1 has a reflection function, and can reflect the light back to the gain region waveguide 11. Therefore, the light is reflected back and forth between the first end face R1 and the second end face R2, to form resonance. The first end face R1 further has a transmission function, and obtained laser light with a narrow linewidth may be emitted through the first end face R1.

In the laser provided in this embodiment of this application, the feedback waveguide connected to the gain region waveguide is disposed, so that an equivalent cavity length of the laser can be increased, to reduce a resonant cavity loss and a threshold gain of the laser, and compress a linewidth of the laser. In addition, the feedback waveguide is monolithically integrated inside the laser, and there is no need to dispose an external cavity outside a cavity of the laser, so that integration of the laser can be improved, and material costs and processing costs of the laser can be reduced.

In this embodiment of this application, a linewidth compression level of the feedback waveguide is related to at least two factors. One factor is an energy value of feedback light, to be specific, power of light reflected back to the gain region waveguide, and the other factor is an optical path length of the light outside the gain region waveguide. The second end face has a reflection function, and light in the feedback waveguide is reflected back when arriving at the second end face. The feedback light may refer to light that is reflected by the second end face and that is transmitted back to the gain region waveguide through the feedback waveguide. A larger length of the feedback waveguide indicates a larger optical path length of the light in the feedback waveguide, and a transmission distance of the light in the feedback waveguide is twice the length of the feedback waveguide.

In a possible implementation, the gain region waveguide 11 may include an indium gallium arsenide phosphide (InGaAsP) material, and the feedback waveguide 12 may include the indium gallium arsenide phosphide (InGaAsP) material. Certainly, the gain region waveguide 11 and the feedback waveguide 12 may alternatively include other materials. This is not limited herein. Impurities of a specific material are doped in both the gain region waveguide 11 and the feedback waveguide 12, and doping concentrations in the gain region waveguide 11 and the feedback waveguide 12 are different, so that the gain region waveguide 11 and the feedback waveguide 12 have different refractive indexes. In addition, the gain region waveguide 11 and the feedback waveguide 12 may be in a straight-line shape, to perform a good optical transmission function.

During specific implementation, a thickness of the gain region waveguide may be less than or equal to 2 micrometers (micrometer, µm), and a thickness of the feedback waveguide may be less than or equal to 2 µm. In this way, the thicknesses of the gain region waveguide and the feedback waveguide are equivalent to a wavelength of light, so that the light in the gain region waveguide and the feedback waveguide satisfies a wave optical transmission rule, and the light can be transmitted inside the gain region waveguide and the feedback waveguide.

In a possible implementation, the laser provided in this embodiment of this application may further include a substrate 10. The substrate 10 is configured to bear the gain region waveguide 11 and the feedback waveguide 12, so that the gain region waveguide 11 and the feedback waveguide 12 can be integrated on the same substrate 10. Optionally, the substrate 10 may include an indium phosphide material, an indium gallium arsenide aluminum material, or an indium gallium aluminum arsenide material. Certainly, the substrate 10 may alternatively include another material. This is not limited herein.

Still referring to FIG. 1, the laser in this embodiment of this application may further include a gain material layer 101. The gain material layer 101 is located between the substrate 10 and the gain region waveguide 11, and the gain material layer 101 may be configured to emit light under control of an electrical signal. During specific implementation, the gain material layer 10 may be disposed in a region corresponding to the gain region waveguide 11. For example, as shown in FIG. 1, the gain material layer 10 may be disposed on the side that is of the dashed line W and that is close to the first end face R1. In this way, light emitted from the gain material layer 101 may be directed into the gain region waveguide 11. A passive material is used between the feedback waveguide 12 and the substrate 10, and the passive material does not emit light under control of an electrical signal, to avoid impact of spontaneous radiation on linewidth broadening of the laser.

In some embodiments of this application, the feedback waveguide 12 may be configured to adjust, under control of an electrical signal, a phase of light transmitted in the feedback waveguide 12. A refractive index of the feedback waveguide 12 may be adjusted by applying the electrical signal to the feedback waveguide 12, to adjust the phase of the light transmitted in the feedback waveguide 12, thereby implementing single-longitudinal-mode lasing of the laser. The laser may further include a first electrode 15. The first electrode 15 may be located at a position corresponding to the feedback waveguide 12, and the first electrode 15 may be configured to provide an electrical signal for the feedback waveguide 12.

As shown in FIG. 1, the laser in this embodiment of this application may further include an electrode layer. The electrode layer may include the first electrode 15, a second electrode 16, and an isolation region 17. The isolation region 17 may be configured to separate the first electrode 15 from the second electrode 16. The first electrode 15 is located at the position corresponding to the feedback waveguide 12, and the first electrode 15 may be configured to provide an electrical signal for the feedback waveguide 12. The second electrode 16 is located at a position corresponding to the gain region waveguide 11, and the second electrode 16 may be configured to provide an electrical signal for the gain material layer 101 of the laser.

The first electrode 15 and the second electrode 16 are separated by the isolation region 17, so that electrical signals between the first electrode 15 and the second electrode 16 can be isolated, thereby separately applying electrical signals to the feedback waveguide 12 and the gain material layer 101. During specific implementation, the isolation region 17 may be a groove located between the first electrode 15 and the second electrode 16. Certainly, in some cases, the isolation region 17 may alternatively be a hole that penetrates the electrode layer, provided that the isolation region 17 can electrically isolate the first electrode 15 and the second electrode 16. A form of the isolation region 17 is not limited herein. A depth of the isolation region 17 may be 0.5 µm to 0.8 µm. For example, the depth of the isolation region 17 may be 0.5 µm, 0.6 µm, or 0.8 µm. A width of the isolation region 17 may be set based on an actual requirement, provided that the isolation region 17 can electrically isolate the first electrode 15 and the second electrode 16. A size of the isolation region 17 is not limited herein.

During specific implementation, the first electrode 15 and the second electrode 16 may be made of a metal material. In a manufacturing process, the first electrode 15 and the second electrode 16 may be manufactured by using a same processing process. Specifically, a metal layer may be formed first, and a region that is between the first electrode 15 and the second electrode 16 and that corresponds to the metal layer is thinned or hollowed out by etching the metal layer, to obtain the isolation region 17 for isolating the first electrode 15 and the second electrode 16.

During actual application, a ground point may be provided in the laser, the first electrode 15 may form a path with the ground point, to provide a current signal for the feedback waveguide 12, and the second electrode 16 may form a path with the ground point, to provide a current signal for the gain material layer 101. In a working process of the laser, a current applied to the first electrode 15 may be different from a current applied to the second electrode 16. For example, the current applied to the first electrode 15 may be 10 mA to 20 mA, and the current applied to the second electrode 16 may be greater than 100 mA. Current values of the first electrode 15 and the second electrode 16 may be set based on an actual requirement. This is not limited herein.

In a possible implementation, the laser in this embodiment of this application may further include a grating structure 13. The grating structure 13 may be located on a side wall of the gain region waveguide 11. The grating structure 13 may be configured to perform mode selection on light transmitted in the gain region waveguide 11. A resonance effect on the light is achieved by using a diffraction effect of the grating structure 13, to select a wavelength.

In the working process of the laser, the gain material layer 101 may emit light in a specific spectral range under control of the electrical signal, and the spectral range is wide. The gain region waveguide 11 and the feedback waveguide 12 do not emit light under action of an electrical signal. Therefore, the gain region waveguide 11 and the feedback waveguide 12 may play a role of optical transmission. Light emitted from the gain material layer 101 is directed into the gain region waveguide 11. The light in the gain region waveguide 11 is directed to the second end face R2 after being transmitted through the feedback waveguide 12. The second end face R2 can reflect the light back to the feedback waveguide 12, so that the reflected light is directed to the first end face R1 after being transmitted through the feedback waveguide 12 and the gain region waveguide 11. The first end face R1 has a reflection function, and can reflect the light back to the gain region waveguide 11. Therefore, the light is reflected back and forth between the first end face R1 and the second end face R2, to form resonance. In a process in which the light is transmitted between the first end face R1 and the second end face R2, the grating structure 13 may perform mode selection on the light transmitted in the gain region waveguide 11, and the feedback waveguide 12 may adjust a phase of the light transmitted in the feedback waveguide 12. A linewidth of the light can be narrowed under action of the grating structure 13 and the feedback waveguide 12, to obtain laser light with a narrow linewidth. The first end face R1 further has the transmission function, and the obtained laser light with the narrow linewidth may be emitted through the first end face R1.

In a possible implementation, the first end face R1 may include an anti-reflection coating, so that the first end face R1 has both a reflection function and a transmission function. For example, transmittance of the first end face R1 may be about 90%, and transmittance of the first end face R1 may be set based on an actual requirement. This is not limited herein. The second end face R2 may include a high reflection coating. For example, reflectivity of the second end face R2 may be about 90%, and the reflectivity of the second end face R2 may be set based on an actual requirement. This is not limited herein. In this way, the light can be reflected back and forth in the gain region waveguide 11 and the feedback waveguide 12 between the first end face R1 and the second end face R2, and formed laser light can be emitted through the first end face R1.

In addition, the laser in this embodiment of this application may further include a protective layer 14 located on a side that is of the gain region waveguide 11 and the feedback waveguide 12 and that is away from the substrate 10, and the electrode layer may be located on a side that is of the protective layer 14 and that is away from the substrate 10. The gain region waveguide 11, the feedback waveguide 12, and the grating structure 13 can be protected by disposing the protective layer 14, to prevent the gain region waveguide 11, the feedback waveguide 12, and the grating structure 13 from being damaged by a subsequent manufacturing process.

Still referring to FIG. 1, in some embodiments of this application, a length of the grating structure 13 may be consistent with a length of the gain region waveguide 11. In this way, a mode selection effect of the grating structure 13 may be good. In a possible implementation, the grating structure 13 may be located on a side that is of the gain region waveguide 11 and that is away from the substrate 10. In a manufacturing process, after the gain region waveguide 11 and the feedback waveguide 12 are formed on the substrate 10, the grating structure 13 may be formed on the gain region waveguide 11. In this way, the gain region waveguide 11 can be manufactured on a flat surface. Certainly, in some cases, the grating structure 13 may alternatively be disposed on a side that is of the gain region waveguide 11 and that is close to the substrate 10, or the grating structure 13 may be disposed on both a side that is of the gain region waveguide 11 and that is close to the substrate 10 and a side that is of the gain region waveguide 11 and that is away from the substrate 10. This is not limited herein.

FIG. 2 is a distribution diagram of an internal optical field of a laser. (1) in FIG. 2 is a distribution diagram of an optical field of a laser without a feedback waveguide. (2) in FIG. 2 is a distribution diagram of an optical field of a laser with the feedback waveguide. In (1) and (2) in FIG. 2, a horizontal axis represents positions from a first end face to a second end face inside the laser, a larger value of a horizontal coordinate represents that the position is closer to the second end face, and a vertical axis represents energy densities at different positions inside the laser. As shown in (1) in FIG. 2, in the laser without the feedback waveguide, energy mainly concentrates at a middle position of the laser. As shown in (2) in FIG. 2, in this embodiment of this application, after the feedback waveguide is disposed in the laser, energy mainly concentrates at a middle position to the right (which is near the second end face) of the laser, that is, the energy of the laser shifts towards a side close to the feedback waveguide.

It can be learned from FIG. 2 that the energy in the laser mainly concentrates at a position, and this causes a relatively large consumption of light at a position where the energy concentrates. As a result, a single-mode characteristic of the laser is damaged, and a yield rate of lasers is affected. This phenomenon is a spatial hole burning effect. The yield rate may refer to a proportion of lasers that meet a requirement in a batch of lasers. To suppress the spatial hole burning effect of the laser, a specific structure of the grating structure is improved in this embodiment of this application. Details are as follows:

FIG. 3 is a diagram of a structure of a grating structure according to an embodiment of this application. As shown in FIG. 3, the grating structure 13 may include a first adjustment region Q1 and a phase-shift adjustment region P. A grating period of the phase-shift adjustment region P is greater than a grating period of the first adjustment region Q1. The phase-shift adjustment region P with a relatively large grating period is provided, to adjust light field distribution in the laser, so that the light field distribution is flatter, and the spatial hole burning effect is reduced, thereby improving the yield rate of lasers. After the feedback waveguide is disposed in the laser, the energy of the laser may shift towards the side close to the feedback waveguide. In this embodiment of this application, a central point of the phase-shift adjustment region P may be located on a side that is of a middle position of the grating structure 13 and that is close to the feedback waveguide. In this way, the phase-shift adjustment region P is close to a position where energy concentrates in the laser, so that the light field distribution is flatter, and the spatial hole burning effect is more effectively prevented.

In a possible implementation, the grating structure 13 may be divided into two regions, namely, the first adjustment region Q1 and the phase-shift adjustment region P. FIG. 4 is a diagram of another structure of a grating structure according to an embodiment of this application. As shown in FIG. 4, in another possible implementation, the grating structure 13 may alternatively be divided into three regions. In addition to the first adjustment region Q1 and the phase-shift adjustment region P, the grating structure 13 may further include a second adjustment region Q2. The phase-shift adjustment region P may be located between the first adjustment region Q1 and the second adjustment region Q2, and a grating period of the phase-shift adjustment region P is greater than a grating period of the second adjustment region Q2. During specific implementation, a specific structure of the grating structure 13 may be set based on an actual requirement. This is not limited herein.

In a possible implementation, a length of the phase-shift adjustment region P may be any value (including endpoint values) between 25% and 30% of the length of the grating structure 13. To be specific, the length of the phase-shift adjustment region P may be greater than or equal to 25% of the length of the grating structure 13, and the length of the phase-shift adjustment region P is less than or equal to 30% of the length of the grating structure 13. For example, the length of the grating structure 13 may be about 1000 µm, and the length of the phase-shift adjustment region P may be about 300 µm. In this way, the length of the phase-shift adjustment region P may meet a requirement for adjusting the light field distribution of the laser.

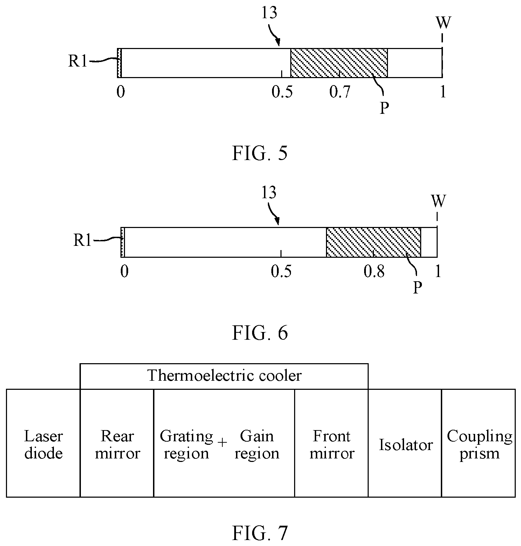

FIG. 5 is a diagram of a position of a phase-shift adjustment region according to an embodiment of this application. FIG. 6 is a diagram of another position of a phase-shift adjustment region according to an embodiment of this application. With reference to FIG. 5 and FIG. 6, the length of the grating structure 13 is normalized, an end that is of the grating structure 13 and that is close to the first end face R1 is used as 0, and an end that is of the grating structure 13 and that is close to the second end face (that is, a position of the dashed line W) is used as 1. A central point of the phase-shift adjustment region P is located at a position that is 0.7 to 0.8 (including endpoint values) of the length of the grating structure 13. In this way, a position of the phase-shift adjustment region P can better match a position where energy concentrates in the laser, and a spatial hole burning effect can be more effectively suppressed. For example, in FIG. 5, the central point of the phase-shift adjustment region P is located at a position that is 0.7 of the length of the grating structure 13. An example in which the length of the grating structure 13 is about 1000 µm is still used. The phase-shift adjustment region P may be located at a position of 550 µm to 850 µm of the length of the grating structure 13. For another example, in FIG. 6, the central point of the phase-shift adjustment region P is located at a position of 0.8 of the length of the grating structure 13. An example in which the length of the grating structure 13 is about 1000 µm is still used. The phase-shift adjustment region P may be located at a position of 650 µm to 950 µm of the length of the grating structure 13.

In the laser provided in this embodiment of this application, the feedback waveguide is disposed, so that an equivalent cavity length of the laser can be increased, to compress a linewidth of the laser. In addition, the feedback waveguide is integrated inside the laser, and there is no need to dispose an external cavity outside a cavity of the laser, so that integration of the laser can be improved, a volume of the laser can be reduced, and material costs and processing costs of the laser can be reduced.

FIG. 7 is a diagram of a structure of a DFB laser according to an embodiment of this application. As shown in FIG. 7, the DFB laser in this embodiment of this application may include structures such as a laser diode (photo diode, PD), a rear mirror, a grating region and a gain region, a front mirror, an isolator, a coupling prism, and a thermoelectric cooler (thermoelectric cooler, TEC). The DFB laser in this embodiment of this application has a simple structure and a small volume.

Based on a same technical concept, an embodiment of this application further provides an optical module. The optical module in this embodiment of this application may include any laser described above. Because the feedback waveguide connected to the gain region waveguide is disposed in the laser, the linewidth of the laser emitted by the laser is narrow. Therefore, an optical signal transmission effect of the optical module including the laser is good. The optical module in this embodiment of this application may further include a silicon optical modulator. The first end face of the laser is connected to the silicon optical modulator. During actual application, a set current may be applied to the laser, so that the laser outputs fixed light intensity. An internal refractive index of the silicon optical modulator is adjusted, so that laser light emitted by the laser interferes with each other. Coherence enhancement and coherence reduction of light are used to represent 0 or 1, thereby implementing transmission of an optical signal.

Based on a same technical concept, an embodiment of this application further provides an apparatus. The apparatus may include any laser described above. Because the feedback waveguide connected to the gain region waveguide is disposed in the laser, the linewidth of the laser emitted by the laser is narrow. Therefore, performance of the apparatus including the laser is also good.

In a possible implementation, the apparatus may be any apparatus in a cellular system related to the 3^{rd} generation partnership project (3^{rd} generation partnership project, 3GPP), for example, any apparatus in a 4G or 5G mobile communication system, or a future-oriented evolved system (for example, a 6G mobile communication system). Alternatively, the apparatus may be any apparatus in an open radio access network (open radio access network, O-RAN or ORAN) or a cloud radio access network (cloud radio access network, CRAN). The apparatus may alternatively be any apparatus in a communication system that integrates the foregoing two or more systems.

The apparatus may alternatively be referred to as an access network device, a RAN entity, an access node, or the like, and forms a part of a communication system, to help a terminal implement radio access. In a possible scenario, the apparatus may be a base station, an evolved nodeB (evolved nodeB, eNodeB), an access point (access point, AP), a transmission reception point (transmission reception point, TRP), a next generation nodeB (next generation nodeB, gNB), a next generation nodeB in a 6^{th} generation (6^{th} generation, 6G) mobile communication system, a base station in a future mobile communication system, an access node in a Wi-Fi system, or the like. The apparatus may be a macro base station, a micro base station, an indoor base station, a relay node, a donor node, or a radio controller in a CRAN scenario. Optionally, the apparatus may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, the apparatus may be a central unit (central unit, CU), a distributed unit (distributed unit, DU), a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may have different names, but a person skilled in the art may understand their meanings. For example, in an ORAN system, the CU may alternatively be referred to as an O-CU (that is, an open CU), the DU may alternatively be referred to as an O-DU, the CU-CP may alternatively be referred to as an O-CU-CP, the CU-UP may alternatively be referred to as an O-CU-UP, and the RU may alternatively be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination thereof.

During specific implementation, the apparatus in this embodiment of this application may alternatively be another apparatus including the laser. A type of the apparatus in this embodiment of this application is not limited herein.

In some implementations of this application, the apparatus may further include an optical module, and the optical module includes the laser. In other words, the laser may be integrated into the optical module. During specific implementation, the laser may alternatively be disposed in another component of the apparatus. For example, the laser may alternatively be disposed in a baseband processing unit (building baseband unit, BBU). Optionally, the laser may be directly integrated onto a baseband board of the BBU.

In some implementations of this application, the laser may be located on a circuit board of the apparatus. For example, the laser may be directly integrated onto the circuit board, or the laser may be pluggably disposed on the circuit board, and may be disposed based on an actual requirement. In this way, costs of the optical module are saved, and a size of the apparatus is reduced.

Although example embodiments of this application are described, a person skilled in the art can make changes and modifications to these embodiments after they learn of a basic inventive concept. Therefore, the following claims are intended to be construed as to cover the preferred embodiments and all changes and modifications falling within the scope of this application.

Clearly, a person skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A laser, comprising a gain region waveguide, a feedback waveguide, a first end face, and a second end face, wherein
the gain region waveguide and the feedback waveguide are located between the first end face and the second end face, an end of the gain region waveguide is connected to an end of the feedback waveguide, and the feedback waveguide is located on a side that is of the gain region waveguide and that is close to the second end face; and
the first end face and the second end face are configured to transmit light in the gain region waveguide and the feedback waveguide, and the first end face is configured to transmit laser light.

2. The laser according to claim 1, wherein the feedback waveguide is configured to adjust, under control of an electrical signal, a phase of light transmitted in the feedback waveguide.

3. The laser according to claim 2, further comprising a first electrode, wherein
the first electrode is located at a position corresponding to the feedback waveguide, and the first electrode is configured to provide an electrical signal for the feedback waveguide.

4. The laser according to any one of claims 1 to 3, further comprising an electrode layer, wherein
the electrode layer comprises the first electrode, a second electrode, and an isolation region;
the isolation region is configured to separate the first electrode from the second electrode;
the first electrode is located at the position corresponding to the feedback waveguide, and the first electrode is configured to provide an electrical signal for the feedback waveguide; and
the second electrode is located at a position corresponding to the gain region waveguide, and the second electrode is configured to provide an electrical signal for a gain material layer of the laser.

5. The laser according to claim 4, wherein a depth of the isolation region is 0.5 micrometer to 0.8 micrometer.

6. The laser according to any one of claims 1 to 5, further comprising a grating structure, wherein
the grating structure is located on a side wall of the gain region waveguide, and the grating structure is configured to perform mode selection on light transmitted in the gain region waveguide.

7. The laser according to claim 6, wherein the grating structure comprises a first adjustment region and a phase-shift adjustment region;
a grating period of the phase-shift adjustment region is greater than a grating period of the first adjustment region; and
a central point of the phase-shift adjustment region is located on a side that is of a middle position of the grating structure and that is close to the feedback waveguide.

8. The laser according to claim 7, wherein a length of the phase-shift adjustment region is 25% to 30% of a length of the grating structure.

9. The laser according to claim 7 or 8, wherein the length of the grating structure is normalized, an end that is of the grating structure and that is close to the first end face is used as 0, and an end that is of the grating structure and that is close to the second end face is used as 1; and the central point of the phase-shift adjustment region is located at a position that is 0.7 to 0.8 of the length of the grating structure.

10. The laser according to any one of claims 6 to 9, wherein the length of the grating structure is consistent with a length of the gain region waveguide.

11. The laser according to any one of claims 6 to 9, further comprising a substrate, wherein
the substrate is configured to bear the gain region waveguide and the feedback waveguide; and
the grating structure is located on a side that is of the gain region waveguide and that is away from the substrate.

12. The laser according to claim 11, further comprising the gain material layer, wherein
the gain material layer is located between the substrate and the gain region waveguide, and the gain material layer is configured to emit light under control of an electrical signal.

13. The laser according to any one of claims 1 to 12, wherein a thickness of the gain region waveguide is less than or equal to 2 micrometers, and a thickness of the feedback waveguide is less than or equal to 2 micrometers.

14. The laser according to any one of claims 1 to 13, wherein the first end face comprises an anti-reflection coating, and the second end face comprises a high reflection coating.

15. The laser according to any one of claims 1 to 14, wherein the laser is a distributed feedback laser.

16. An optical module, comprising the laser according to any one of claims 1 to 15.

17. The optical module according to claim 16, further comprising a silicon optical modulator, wherein a first end face of the laser is connected to the silicon optical modulator.

18. An apparatus, comprising the laser according to any one of claims 1 to 15.

19. The apparatus according to claim 18, wherein the apparatus is a wireless unit or a distributed unit.

20. The apparatus according to claim 18 or 19, further comprising an optical module, wherein
the optical module comprises the laser.
